# EUROPEAN PATENT APPLICATION

(11) **EP 4 852 623 A1**
(43) Date of publication of application: **09.12.2026**
(21) Application number: 25749135.7
(22) Date of filing: 22.01.2025
(51) Int. Cl.: H05K 1/02, H05K 3/00

(54) **PRINTED CIRCUIT BOARD**

(30) Priority: 29.01.2024 KR 20240013333; 08.04.2024 KR 20240047134
(71) Applicant: Yura Corporation Co., Ltd., Seongnam-si, Gyeonggi-do 13494 (KR)
(72) Inventor: KANG, Byung Kwan, Gwangju-si, Gyeonggi-do 12787 (KR); JUNG, Gil Woo, Seongnam-si, Gyeonggi-do 13494 (KR)
(74) Representative: ABG Intellectual Property Law, S.L.
(86) International application number: PCT/KR2025/001229
(87) International publication number: WO 2025/165048

(57) **Abstract**

A printed circuit board according to an embodiment of the present disclosure comprises: a substrate portion in which first and second insulating layers are formed one above the other, and a circuit layer is formed between the first and second insulating layers; an electronic component mounted in an exposed area where the circuit layer is exposed by removing a portion of the first insulating layer; and a component reinforcing portion attached to the second insulating layer of the exposed area and configured to support the electronic component. The component reinforcing portion includes a component reinforcing plate bonded to the second insulating layer of the exposed area, a component adhesive layer formed between the second insulating layer and the component reinforcing plate, and a fuse adhesive layer formed on a surface of the component reinforcing plate opposite to the component adhesive layer. The substrate portion further includes a pattern fuse portion formed such that a portion of the circuit layer is configured to function as a fuse. The pattern fuse portion includes a fusing portion configured to fuse faster than other portions of the circuit layer at or above a predetermined current. One surface of the pattern fuse portion is attached and fixed to the fuse adhesive layer. Accordingly, the electronic component may be firmly supported, the flatness of the pattern fuse may be maintained, and the printed circuit board may be firmly fixed to a counterpart, without increasing weight and volume.

## Description

### TECHNICAL FIELD

The present disclosure relates to a printed circuit board, and more particularly, to a printed circuit board in which an internal circuit is printed and electrically connected to other components to complete a circuit.

### BACKGROUND ART

A printed circuit board is a circuit board on which an internal circuit is patterned and printed to fix and connect a plurality of electronic components in a standardized manner, and it realizes miniaturization and weight reduction of electronic products by mechanically and electrically coupling a plurality of circuits.

A printed circuit board has advantages such as stabilized circuit characteristics, no risk of miswiring, and low production cost. Due to these various advantages, the printed circuit board is used in various fields and is becoming a key component used in many electronic devices. In particular, in line with the recent trend of miniaturization and weight reduction, the use of flexible printed circuit boards is increasing.

On one side of such a printed circuit board, electronic components such as connectors and terminals are mounted and connected to each circuit. In this case, to prevent damage to the printed circuit board, particularly a flexible printed circuit board, a reinforcing plate is attached to the other side using an adhesive. However, when soldering is performed for the electrical connection between the electronic components and each circuit, the temperature rises due to the soldering, causing air bubbles within the adhesive to expand. This expansion reduces the stability of the electrical connection with the electronic components and decreases flatness, leading to defects.

In addition, when a reinforcing plate is used to fix various electronic components, there is a disadvantage that the weight and volume are increased.

Therefore, there is an increasing demand for a lighter printed circuit board that can stably accommodate various electronic components.

### DISCLOSURE OF THE INVENTION

### TECHNICAL PROBLEM

An embodiment of the present disclosure is devised to solve the above-mentioned problems, and an object thereof is to provide an overall lightweight printed circuit board that may reduce the defect rate during soldering of electronic components, and may have improved product reliability and productivity, while also reducing weight and volume.

### TECHNICAL SOLUTION

An embodiment of the present disclosure provides a printed circuit board comprising: a substrate portion in which first and second insulating layers are formed one above the other, and a circuit layer is formed between the first and second insulating layers; an electronic component mounted in an exposed area where the circuit layer is exposed by removing a portion of the first insulating layer; and a component reinforcing portion attached to the second insulating layer of the exposed area and configured to support the electronic component, wherein the component reinforcing portion comprises a component reinforcing plate bonded to the second insulating layer of the exposed area, a component adhesive layer formed between the second insulating layer and the component reinforcing plate, and a fuse adhesive layer formed on a surface of the component reinforcing plate opposite to the component adhesive layer, wherein the substrate portion further comprises a pattern fuse portion formed such that a portion of the circuit layer is configured to function as a fuse, wherein the pattern fuse portion comprises a fusing portion configured to fuse faster than other portions of the circuit layer at or above a predetermined current, and wherein one surface of the pattern fuse portion is attached and fixed to the fuse adhesive layer.

The component reinforcing portion may further comprise a discharge path configured to discharge air bubbles within the component adhesive layer.

The electronic component may comprise a connection portion that is electrically connected by soldering to the circuit layer exposed in the exposed area, and the discharge path may be formed at a position corresponding to the connection portion.

The discharge path may comprise a horizontal discharge path formed by removing the component adhesive layer at the position of the connection portion, and a vertical discharge path formed to pass through the component reinforcing plate so as to be in communication with the horizontal discharge path.

The fuse adhesive layer may be formed on a remaining portion excluding a position corresponding to the fusing portion to form an air gap at the position corresponding to the fusing portion, and the vertical discharge path may be formed to be in communication with the air gap.

The discharge path may be formed as an air tunnel in which the component adhesive layer is removed from a position of the connection portion to one side end of the exposed area.

The discharge path may be formed as an air hole that penetrates the component reinforcing plate and the component adhesive layer at a position of the connection portion.

A fixing circuit to which the electronic component is fixed by soldering may be formed in the exposed area, and the discharge path may be additionally formed at a position corresponding to a position of the fixing circuit.

The component reinforcing portion may further comprise a component reinforcing portion fixing hole formed through the component reinforcing portion.

The fuse adhesive layer may be formed on a remaining portion excluding a position corresponding to the fusing portion, thereby forming an air gap at the position corresponding to the fusing portion.

The pattern fuse portion may further comprise connection pads formed at both ends of the fusing portion.

A width of the connection pads may be wider than a width of the fusing portion.

At least one of the first insulating layer or the second insulating layer may not be formed at a location where the connection pad is formed, such that the connection pad is exposed to an exterior.

A protective coating liquid may be applied on an upper side of the connection pad.

The pattern fuse portion may further include an interference prevention portion surrounding the fusing portion, wherein the circuit layer is removed in the interference prevention portion.

The pattern fuse portion may further include a concentrated fusing portion in which at least one of the first insulating layer or the second insulating layer is open over at least a portion of the fusing portion.

A protective coating liquid may be applied to an opened surface of the concentrated fusing portion.

The pattern fuse portion may further include an overflow prevention portion formed as a closed curve surrounding the pattern fuse portion and protruding from at least one of the first insulating layer or the second insulating layer.

The pattern fuse portion may be implemented to include: a connection wiring connected to one end of the fusing portion; and a connection pad formed to be connected to the connection wiring.

### ADVANTAGEOUS EFFECTS

As described above, according to the solutions provided by the present disclosure, various effects including the following may be anticipated. However, it is not necessary for an embodiment of the present disclosure to achieve all of the following effects.

A printed circuit board according to an embodiment of the present disclosure may use a single component reinforcing plate to simultaneously support an electronic component and a pattern fuse portion. This configuration may firmly support the electronic component and maintain the flatness of the pattern fuse without increasing weight and volume, and may also allow for firm fixing to a counterpart.

Furthermore, a discharge path for discharging air bubbles within an adhesive layer is formed at a position corresponding to the exposed area where the electronic component is mounted. This may prevent lifting of the electronic component and provide a more stable electrical connection with the circuit layer.

Additionally, degradation of the flatness of the printed circuit board due to lifting of the electronic component may be prevented, which may reduce the defect rate. Also, the fixing force of the electronic component may be secured, which may improve durability against continuous vibrations due to vehicle operation.

Furthermore, in a discharge path according to another embodiment, a discharge path is formed to pass through the component reinforcing plate, so that air bubbles generated in the component adhesive layer are promptly removed in a stacking direction, which may enhance the effects described above.

Additionally, by providing the air gap, changes in the fusing characteristic and conduction characteristic, which may occur due to the fuse adhesive layer being attached to the fusing portion, may be prevented.

In particular, when the fusing portion fuses, the fuse adhesive layer may be prevented from being carbonized due to high temperatures and affecting other circuits.

Additionally, defects in the pattern fuse portion may be tested in advance during a manufacturing stage via the connection pads.

Furthermore, by providing the interference prevention portion, the concentrated fusing portion, and the overflow prevention portion, the reliability of the fusing characteristic of the fusing portion may be increased.

### BRIEF DESCRIPTION OF THE DRAWINGS

FIGS. 1 to 7 illustrate a printed circuit board according to a first embodiment of the present disclosure.
FIG. 1 is a perspective view of the printed circuit board in a state where the pattern fuse portion is unfolded.
FIG. 2 is a bottom perspective view of FIG. 1.
FIG. 3 is an exploded perspective view of FIG. 2.
FIG. 4 is an enlarged view of the pattern fuse portion of FIG. 1.
FIG. 5 is a perspective view of the printed circuit board of FIG. 1, showing a state in which a pattern fuse portion is overlapped with a component reinforcing portion.
FIG. 6 is a bottom perspective view of FIG. 5.
FIG. 7 is a cross-sectional view taken along the line VII-VII of FIG. 5.
FIG. 8 is a cross-sectional view taken along the line VIII-VIII of FIG. 4.
FIG. 9 is a cross-sectional view taken along the line IX-IX of FIG. 4.
FIG. 10 is a plan view illustrating a modified example of the connection pad of FIG. 4.
FIGS. 11 and 12 illustrate a second embodiment of a discharge path.

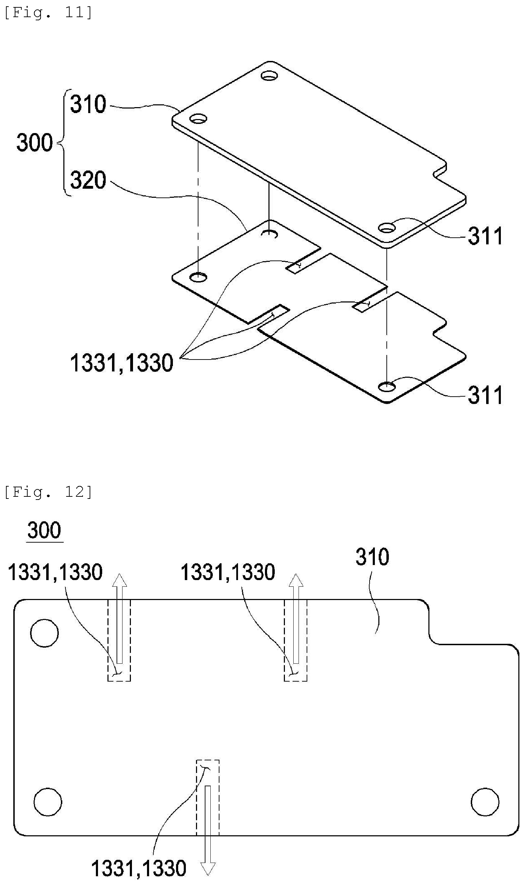

FIG. 11 is an exploded perspective view illustrating a component adhesive layer and a component reinforcing plate.
FIG. 12 is a plan view of FIG. 11.

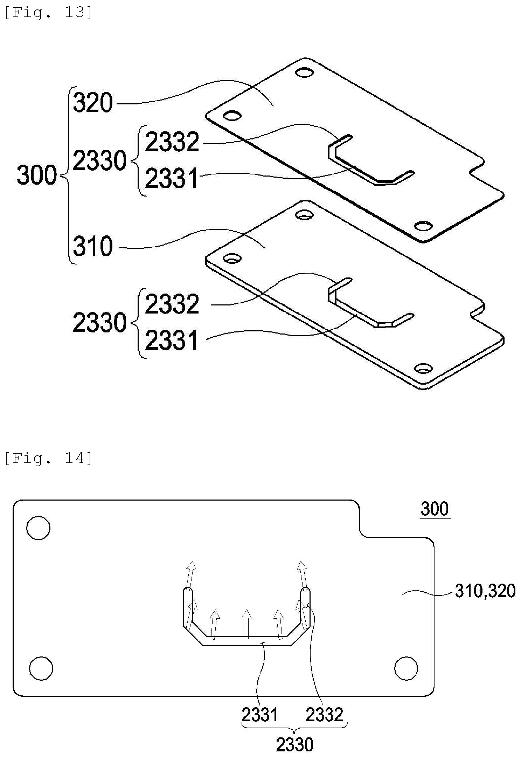

FIGS. 13 and 14 illustrate a third embodiment of the discharge path.
FIG. 13 is an exploded perspective view illustrating the component adhesive layer and the component reinforcing plate.
FIG. 14 is a plan view of FIG. 13.

### MODE FOR CARRYING OUT THE INVENTION

Hereinafter, specific embodiments of the present disclosure will be described in detail with reference to the drawings. However, descriptions of known functions or configurations will be omitted so as not to obscure the gist of the present disclosure.

In addition, for convenience of description, a direction in which the printed circuit board extends is defined as an extending direction, a direction in which the insulating layer and the circuit layer are stacked is defined as a stacking direction, a direction in which a connector is mounted is defined as an upper side in the stacking direction, and a direction in which a reinforcing portion is formed is defined as a lower side in the stacking direction.

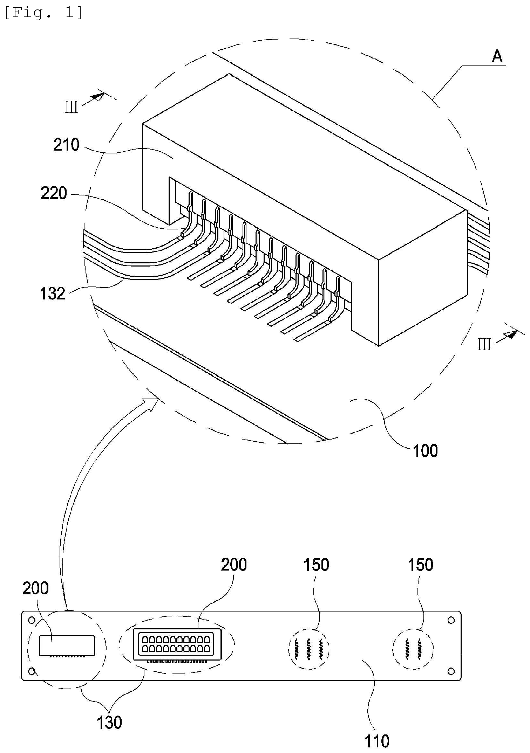

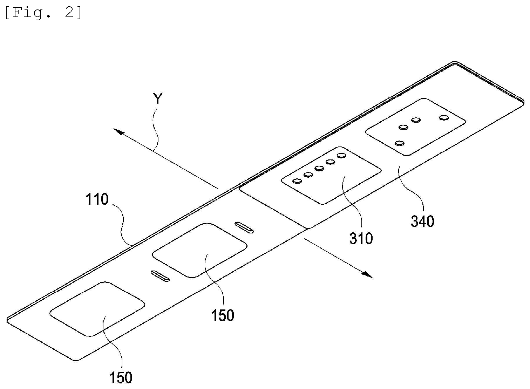

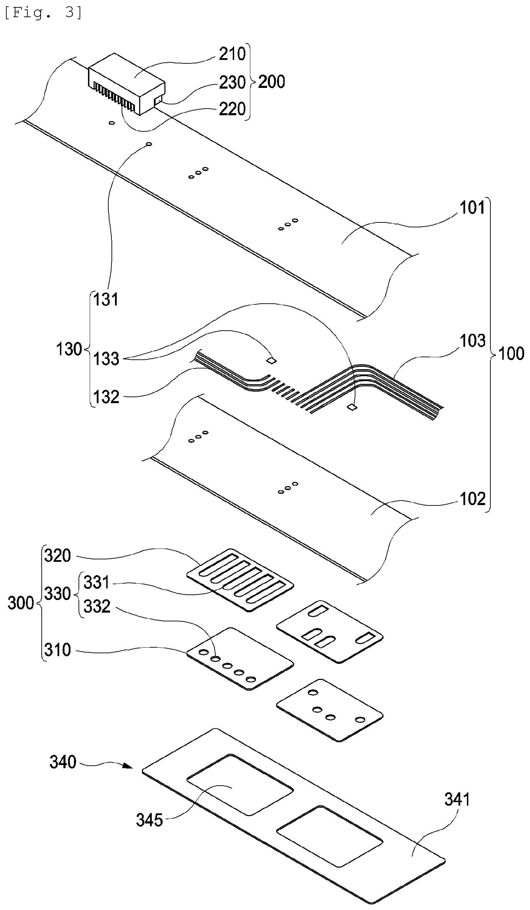

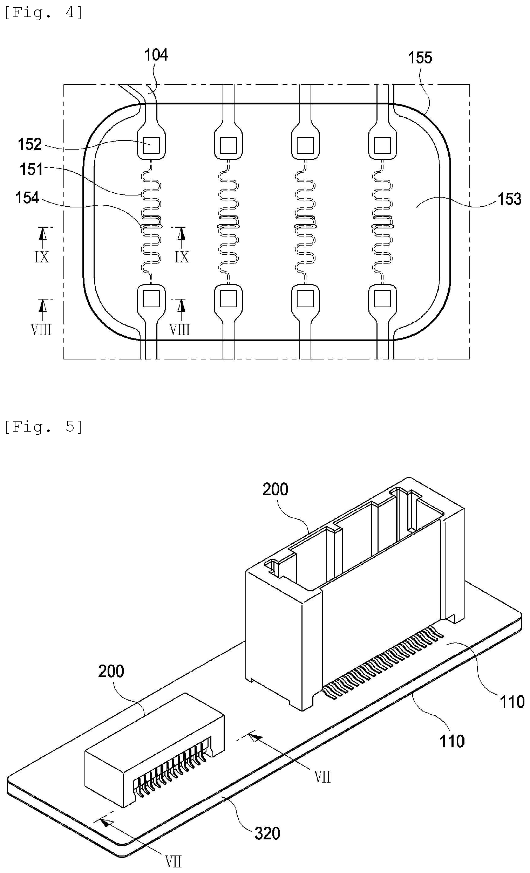

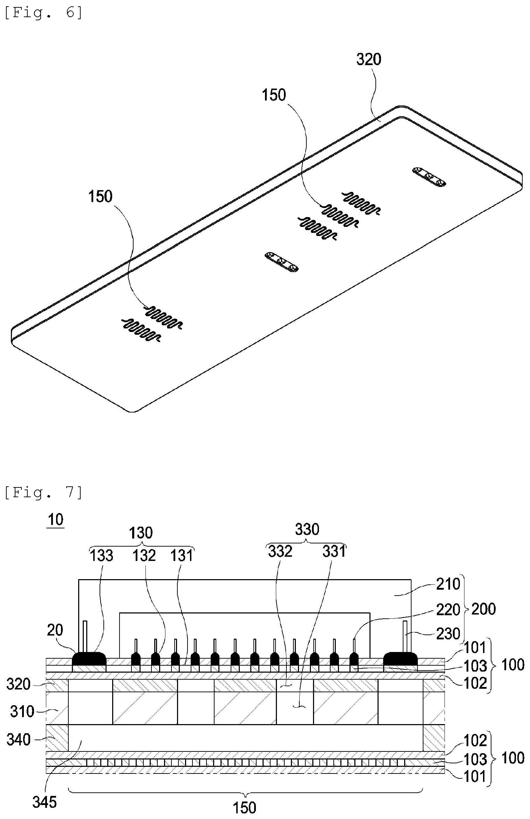

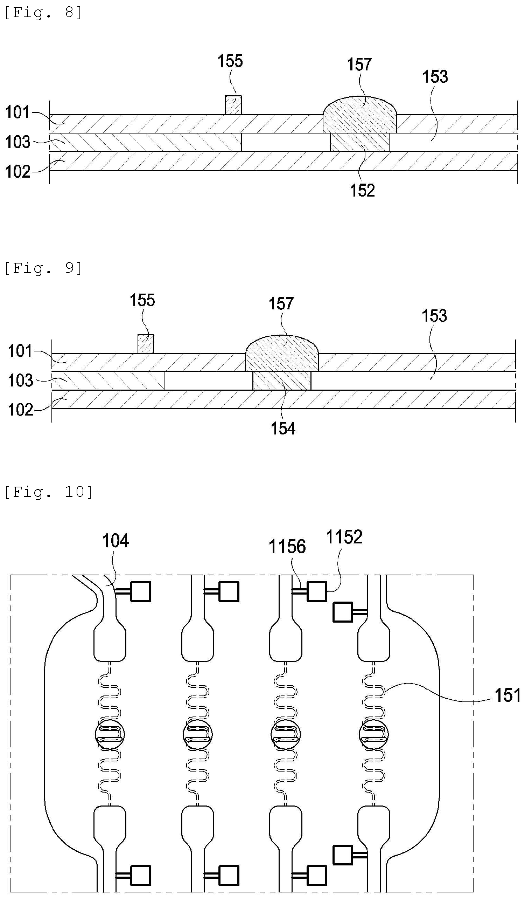

FIGS. 1 to 10 illustrate a printed circuit board according to a first embodiment of the present disclosure, wherein FIG. 1 is a perspective view of the printed circuit board in a state where the pattern fuse portion is unfolded, FIG. 2 is a bottom perspective view of FIG. 1, FIG. 3 is an exploded perspective view of FIG. 2, FIG. 4 is an enlarged view of the pattern fuse portion of FIG. 1, FIG. 5 is a perspective view of the printed circuit board of FIG. 1 in a state where the pattern fuse portion is overlapped with the component reinforcing portion, FIG. 6 is a bottom perspective view of FIG. 5, FIG. 7 is a cross-sectional view taken along line VII-VII of FIG. 5, FIG. 8 is a cross-sectional view taken along line VIII-VIII of FIG. 4, FIG. 9 is a cross-sectional view taken along line IX-IX of FIG. 4, and FIG. 10 is a plan view illustrating a modified example of the connection pad of FIG. 4.

As illustrated in these drawings, a printed circuit board according to a first embodiment of the present disclosure comprises: a substrate portion 100 in which first and second insulating layers 101 and 102 are formed one above the other, and a circuit layer 103 is formed between the first and second insulating layers 101 and 102; an electronic component 200 mounted in an exposed area 131 where the circuit layer 103 is exposed by removing a portion of the first insulating layer 101; and a component reinforcing portion 300 attached to the second insulating layer 102 of the exposed area 131 and configured to support the electronic component 200.

The substrate portion 100 includes a circuit layer 103 in which an internal circuit is formed as a pattern, a first insulating layer 101 stacked on an upper side of the circuit layer 103 in the stacking direction, and a second insulating layer 102 stacked on a lower side of the circuit layer 103 in the stacking direction, thereby electrically connecting an external component and the circuit layer 103 to complete a plurality of circuits. In this case, the first and second insulating layers 101 and 102 support the thinly formed circuit layer 103 to prevent the internal circuit from being damaged, such as by disconnection, and protect the circuit layer 103 by preventing phenomena such as short circuits with other surrounding components. Therefore, the circuit layer 103 is formed with a plurality of internal circuits as patterns, and the first and second insulating layers 101 and 102 are formed to cover the entire internal circuit from both sides in the stacking direction so that the entire circuit layer 103 is not exposed to the exterior.

While the components constituting the substrate portion 100 in the thickness direction have been described above, components of the substrate portion 100 that are arranged in a planar manner and distinguished by shape or function will now be described in more detail.

The substrate portion 100 includes: a body portion 110, which is vertically formed of the aforementioned first and second insulating layers 101 and 102 and the circuit layer 103; and, distinguished by function in a horizontal direction, a component mounting portion 130 on which the aforementioned electronic component 200 is mounted, and a pattern fuse portion 150 formed such that a portion of the circuit layer 103 is configured to function as a fuse.

The pattern fuse portion 150 comprises: a fusing portion 151 configured to fuse faster than other portions of the circuit layer 103 at or above a predetermined current; connection pads 152 formed at both ends of the fusing portion 151; an interference prevention portion 153 surrounding the fusing portion 151, in which the circuit layer 103 is removed; a concentrated fusing portion 154 in which at least one of the first insulating layer 101 or the second insulating layer 102 is open over at least a portion of the fusing portion 151; and an overflow prevention portion 155 formed as a closed curve surrounding the pattern fuse portion 150 and protruding from at least one of the first insulating layer 101 or the second insulating layer 102.

The pattern fuse portion 150 may be formed of a single fusing portion 151, but as shown in FIG. 4, a plurality of fusing portions 151 may be formed in a cluster. The interference prevention portion 153 and the overflow prevention portion 155 are formed to surround the entirety of the plurality of fusing portions 151.

The fusing portion 151 is formed to have a smaller cross-sectional area than other circuit wiring 104 of the circuit layer 103, so that when a current at or above a predetermined level flows, it fuses before the other circuit wiring 104. In addition, as illustrated in FIG. 4, the fusing portion 151 is formed with a narrow line width to increase resistance and is formed in a zigzag shape to increase its length. A plurality of such fusing portions 151 may be formed. By forming the pattern fuse portion 150 as described above, compared to using a chip fuse, the weight may be reduced, and manufacturing costs may also be reduced.

The connection pads 152 are formed to be wider than a width of the fusing portion 151 and are respectively formed at both ends of the fusing portion 151. The connection pads 152 are necessary for a performance test of the pattern fuse and are used for a resistance test of the fusing portion 151 during or after a manufacturing process. Therefore, the connection pads 152 may be continuously exposed, or may be exposed only during a testing stage in the manufacturing process to prevent unnecessary contamination. That is, at least one of the first insulating layer 101 or the second insulating layer 102 where the connection pads 152 are formed is not formed, such that the connection pads 152 are exposed to an exterior, or, as shown in FIG. 8, a protective coating liquid 157 may be applied on an upper side of the connection pads 152 after testing so that the connection pads 152 are not exposed after manufacturing. Alternatively, after testing with only one of the first and second insulating layers 101, 102 formed, the remaining insulating layer may be heat-fused so that the connection pads 152 are not exposed. Since the shape of the connection pads 152 is a test point for resistance measurement, it may be variously formed as a rectangle, a circle, a polygon, or the like, as needed.

Furthermore, as illustrated in FIG. 10, the connection pads 152 may not be formed directly at both ends of the fusing portion 151, but may be formed separately. That is, the pattern fuse portion 150 may include a connection wiring 1156 connected to one end of the fusing portion 151, and a connection pad 1152 formed to be connected to the connection wiring 156. The connection pad 1152 is formed at a position spaced apart from the fusing portion 151, and the connection wiring 156 connects the fusing portion 151 and the connection pad 1152, thereby allowing the connection pad 152, which occupies a large area, to be disposed outward, which may increase the degree of freedom in design.

The interference prevention portion 153 is an area where the circuit layer 103, that is, a conductive conductor, in a region surrounding the fusing portion 151 is removed. By removing the conductive conductor in the region surrounding the fusing portion 151 in this manner, the electrical characteristics of the pattern fuse may be maintained consistently. If a conductor is present in the vicinity of the fusing portion 151, the electrical characteristics change due to effects such as heat dissipation, and the interference prevention portion 153 prevents such changes.

The concentrated fusing portion 154 is a portion where at least one of the first and second insulating layers 101, 102 is open in a predetermined area of the fusing portion 151, which is a central area in the present disclosure. This opening prevents the fusing characteristic of the fusing portion 151 from being altered by the first and second insulating layers 101, 102. In addition, to protect the opened portion, as shown in FIG. 9, a protective coating liquid 157 may be applied to an opened surface of the concentrated fusing portion 154.

The overflow prevention portion 155 is formed to surround the pattern fuse portion 150 and to protrude upward on one surface of the first and second insulating layers 101, 102, that is, the surface to which a protective coating liquid 156 is applied. A manufacturing method involves forming it to protrude upward from the first and second insulating layers 101, 102 by a method such as screen printing. The overflow prevention portion 155 prevents the protective coating liquid 157 applied on an upper side of the concentrated fusing portion 154 or the connection pads 152 from overflowing to other parts of the circuit board. Alternatively, when a coating liquid is applied to an upper surface of the pattern fuse portion 150 to ensure the performance of the pattern fuse portion 150, it provides a guideline for the coating area, prevents coating in unnecessary areas, reduces the required amount of coating liquid, and, if the coating liquid overflows, allows for easier recognition and determination of defects.

As described above, an embodiment of the present disclosure includes a pattern fuse portion, which may reduce the overall weight compared to when a chip fuse is used.

Furthermore, through the connection pads, defects in the pattern fuse portion may be tested in advance during a manufacturing stage.

Furthermore, by providing an interference prevention portion, a concentrated fusing portion, and an overflow prevention portion, the reliability of the fusing characteristic of the fusing portion may be enhanced.

A component mounting portion 130 includes: an exposed area 131 formed by removing a portion of a first insulating layer 101 of a body portion 110; an exposed circuit 132 located in the exposed area 131, where the circuit layer 103 is directly electrically connected to an electronic component 200; and a fixing circuit 133 formed in the circuit layer 103 for fixing the electronic component 200 and exposed by the exposed area 131. Herein, the exposed circuit 132 is formed of copper foil and extends in an extending direction, serving as an exposed portion of an internal circuit of the body portion 110 to be electrically connected with the electronic component 200, whereas the fixing circuit 133, although formed of the circuit layer 103 in the form of copper foil, is not connected to the internal circuit and is thus used only for fixing the electronic component 200.

Therefore, the exposed area 131 is formed corresponding to a size of the electronic component 200 to be mounted. As needed, an area where the exposed circuit 132 is exposed and an area where the fixing circuit 133 is exposed may be formed separately. Preferably, a plurality of exposed areas 131 are formed such that the respective exposed circuits 132 and fixing circuits 133 are partitioned and exposed, thereby minimizing exposure of portions other than the portions connected to the electronic component 200 to secure the stability of the circuit layer 103. In summary, the printed circuit board 10 according to an embodiment forms the exposed area 131 where the circuit layer 103 is exposed in the first insulating layer 101 stacked on one side of the circuit layer 103, thereby being directly connected to the electronic component 200 to easily form a plurality of circuits with an external device.

The electronic component 200 is mounted on one side of the printed circuit board 10 and is directly electrically connected to an exposed circuit 131. The electronic component 200 may refer to a connector that relays a connection between an external device and the circuit layer 103, or a sensor, an element, or the like that measures a state of a connected device. For this purpose, the electronic component 200 is formed with a component body 210, a connection portion 220 exposed on one side of the component body 210 and electrically connected to respective exposed circuits 131 by soldering, and a fixing portion 230 fixed to a fixing circuit 132 by soldering. In this case, a plurality of the connection portions 220 are formed to connect with a plurality of respective circuits that form the circuit layer 103, thereby forming a plurality of circuits that serve as paths for electrical signals. The fixing portion 230 is exposed on an outer side of the electronic component 200 and is simply connected to the fixing circuit 132, and does not form a circuit even when connected to the fixing circuit 132 by soldering.

The component reinforcing portion 300 includes a component reinforcing plate 310 bonded to the second insulating layer 102 of the exposed area 131, a component adhesive layer 320 formed between the second insulating layer 102 and the component reinforcing plate 310, a fuse adhesive layer 340 formed on a surface of the component reinforcing plate 310 opposite to the component adhesive layer 320, and a discharge path 330 configured to discharge air bubbles within the component adhesive layer 320. The component reinforcing portion 300 is formed on a second insulating layer 103 corresponding to a position of the exposed area 131 and supports the electronic component 200, and may prevent the flexible printed circuit board 10 from being damaged, such as by tearing, due to the mounting of the electronic component 200. The component reinforcing portion 300 supports the mounted electronic component 200 and may also prevent deformation that can occur in the printed circuit board 10 during soldering, which may significantly improve product reliability and durability.

The component reinforcing plate 310 has rigid physical properties so as to stably support an electronic component 200 having a weight equal to or greater than a predetermined value, such as a connector, even when mounted. It is preferable that the component reinforcing plate 310 has an area capable of accommodating all of the plurality of exposed areas 131 to support the entire area of the electronic component 200. A vertical discharge path 332 is formed to pass through the component reinforcing plate 310.

The component adhesive layer 320 is formed of a material of a double-sided tape having a constant thickness. A release liner is attached to both surfaces before attachment, and the release liner is removed upon attachment. The component adhesive layer 320 is formed such that a discharge path 330 for discharging air bubbles within the component adhesive layer 320, more specifically, a horizontal discharge path 331, is formed to pass therethrough. The horizontal discharge path 331 is formed to be in communication with the vertical discharge path 332.

The component adhesive layer 320 is formed between the second insulating layer 102 and the component reinforcing plate 310 and serves to fix the component reinforcing plate 310 to the second insulating layer 102. At this time, when the electronic component 200 is mounted by soldering while the component reinforcing plate 310 is in an attached state, a temperature of the exposed area 131 rises. Accordingly, air bubbles within the component adhesive layer 320 expand, causing lifting to occur in a mounted portion of the electronic component 200.

To explain in more detail, generally, for the printed circuit board 10, a reflow soldering process is used in which a solder paste 20 is printed in advance on the exposed area 131, and then external heat is supplied to re-melt the solder paste 20 to bond the electronic component 200. The heat supplied at this time has a temperature of approximately 250 °C, and in this case, the volume of air bubbles within the component adhesive layer 320 expands by about two times.

The discharge path 330 includes a horizontal discharge path 331, which is formed by removing the component adhesive layer 320 at a position corresponding to the connection portion 220 and the fixing portion 230, and a vertical discharge path 332, which is formed to pass through the component reinforcing plate 310 in an axial direction so as to be in communication with one side of the horizontal discharge path 331. The discharge path 330 is a passage for discharging expanded air bubbles within the component adhesive layer 320. It is formed at a position corresponding to the exposed circuit 131, that is, a position of the connection portion 220 where the connection portion 220 of the electronic component 200 and the circuit layer 103 are bonded by soldering, and is in communication with an exterior to discharge the air bubbles to the exterior along the discharge path 330.

More specifically, the horizontal discharge path 331 is formed to start at positions of the connection portion 220 and a fixing portion 230 and extend a predetermined length to one side, and the vertical discharge path 332 is formed to be in communication with the horizontal discharge path 331 corresponding to the positions of the connection portion 220 and the fixing portion 230, thereby allowing air bubbles in a portion where soldering is performed to be rapidly discharged in an axial direction, and at the same time, by forming the horizontal discharge path 331 to have a certain length, a travel path of expanded air bubbles around the connection portion 220 and the fixing portion 230 is reduced to facilitate smooth discharge.

The fuse adhesive layer 340 is attached to the component reinforcing plate 310 on a surface opposite to the component adhesive layer 320.

When the substrate portion 100 is folded along a folding line Y of FIG. 2, the pattern fuse portion 150 is attached to the fuse adhesive layer 340, as shown in FIG. 5. In a folded state, the fuse adhesive layer 340 is formed on a remaining portion excluding a position corresponding to the fusing portion 151, thereby forming an air gap 345 at the position corresponding to the fusing portion 151. That is, as illustrated in FIGS. 2 and 3, the fuse adhesive layer 340 includes a fuse adhesive layer body 341 having a quadrangular ring shape that surrounds the air gap 345. The vertical discharge path 332 is formed to be in communication with the air gap 345.

As described above, in the printed circuit board according to a first embodiment, a discharge path configured to discharge air bubbles within the adhesive layer is formed at a position corresponding to the exposed area where an electronic component is mounted. This may prevent lifting of the electronic component and provide a more stable electrical connection with the circuit layer.

In addition, a decrease in the flatness of the circuit board due to the lifting of the electronic component may be prevented, which may reduce a defect rate. At the same time, a fixing force of the electronic component may also be secured, thereby improving durability against continuous vibration due to vehicle operation.

Furthermore, by forming a discharge path that penetrates the component reinforcing plate, air bubbles generated in the adhesive layer may be immediately removed in a stacking direction, which may further enhance the effects described above.

In addition, by using a single component reinforcing plate to simultaneously support the electronic component and the pattern fuse portion, the flatness of the pattern fuse may be maintained, and it may be firmly fixed to a counterpart. Furthermore, by providing the air gap 345, changes in a fusing characteristic and a current-carrying characteristic, which may occur due to the fuse adhesive layer 340 being attached to the fusing portion 151, may be prevented. In particular, when the fusing portion 151 fuses, the fuse adhesive layer 340 may be prevented from being carbonized due to high temperature and affecting other circuits.

FIGS. 11 and 12 illustrate a second embodiment of a discharge path, wherein FIG. 11 is an exploded perspective view illustrating a component adhesive layer and a component reinforcing plate, and FIG. 12 is a plan view of FIG. 8.

As illustrated in these drawings, the discharge path 1330 of the second embodiment is formed as an air tunnel 1331 that extends from positions of the connection portion 220 and a fixing portion 230 of the component adhesive layer 320 to one side end of the component adhesive layer 320. That is, the air tunnel 1331 is formed by removing a portion of the component adhesive layer 320 and is formed in a channel shape extending from a middle portion to a corner. As a result, air bubbles within the component adhesive layer 320 expand and merge with other surrounding air bubbles, gradually increasing in size.

At this time, the expanded air bubbles move to the discharge path 1330, which has a relatively low pressure because a pressing force from the component reinforcing plate 310 is not applied thereto. The air bubbles are then discharged to an exterior through the discharge path 1330, which may prevent lifting from occurring at a mounting portion of the electronic component 200.

Furthermore, since the discharge path 1330 is formed by removing the component adhesive layer 320, which reduces the adhesion area, it is desirable that the discharge path 1330 is formed as a plurality of air tunnels 1331 connected to the nearest terminal ends of the connection portion 220 and the fixing portion 230. In the case of the discharge path 1330 connected to the connection portion 220, it is desirable to form it in a central part of the connection portion 220 to secure contact area while also discharging air bubbles expanding in the vicinity, considering that expanded air bubbles merge with surrounding air bubbles.

In addition, a component reinforcing portion fixing hole 311 is formed through the component reinforcing plate 310. The component reinforcing portion fixing hole 311 is formed to pass through the pattern fuse portion 150, the component adhesive layer 320, the fuse adhesive layer 340, and the component adhesive layer 320. The component reinforcing portion fixing holes 311 are formed in the number and at positions necessary to fix the printed circuit board 10. The component reinforcing portion fixing hole 311 is fixed when a boss or the like, formed on a counterpart to which the printed circuit board 10 is fixed, is inserted and fused therein.

FIGS. 13 and 14 illustrate a third embodiment of the discharge path, wherein FIG. 13 is an exploded perspective view illustrating the component adhesive layer and the component reinforcing plate, and FIG. 14 is a plan view of FIG. 13.

As shown in these drawings, the discharge path 2330 of the third embodiment is formed of a first air hole 2331 that simultaneously penetrates the component reinforcing plate 310 and the component adhesive layer 320 at a position corresponding to the connection portion 220, and a second air hole 2332 that simultaneously penetrates the component reinforcing plate 310 and the component adhesive layer 320 at a position corresponding to the fixing portion 230, thereby discharging expanding air bubbles in a stacking direction.

In this case, for processability and removal of surrounding air bubbles, it is desirable that the first and second air holes 2331 and 2332 are formed to be in communication with each other. Since the discharge path 2330 is formed to simultaneously penetrate the component reinforcing plate 310 and the component adhesive layer 320, the length of the channel through which air bubbles are discharged can be minimized, which may enable more rapid air bubble discharge.

In summary, the discharge path 330, 1330, 2330 of the printed circuit board 10 according to an embodiment of the present disclosure may be formed in various embodiments capable of discharging expanded air bubbles within the component adhesive layer 320. In this case, the discharge path 1330 of the second embodiment allows the component reinforcing plate 310 to support the entire exposed area 131 to maintain support force, and is formed to have a certain length to also allow smooth discharge of air bubbles around the connection portion 220 and the fixing portion 230. However, because the air bubbles are discharged while moving along the air tunnel 1331, rapid discharge may be more difficult than with the axially formed discharge paths 330 and 2330.

Furthermore, the discharge path 2330 of the third embodiment is formed of the first and second air holes 2331 and 2332 that connect both the connection portion 220 and the fixing portion 230, resulting in the largest reduction in the support area of the component reinforcing plate 310. However, the discharge of expanded air bubbles around the connection portion 220 and the fixing portion 230 is smooth, and the entire discharge path 2330 is open in the axial direction, so that air bubbles may be rapidly discharged.

Furthermore, the discharge path 330 of the first embodiment is formed of a horizontal discharge path 331, which is formed by removing the component adhesive layer 320 at the positions of the connection portion 220 and the fixing portion 230, and a vertical discharge path 332 that communicates with the horizontal discharge path 331 at the positions of the connection portion 220 and the fixing portion 230. This may minimize the reduction in the support area, while forming the vertical discharge path 332, which is open in the axial direction at the positions of the connection portion 220 and the fixing portion 230 where soldering is directly performed, to allow air bubbles to be rapidly discharged.

In this case, the horizontal discharge path 331 is formed to extend a predetermined length to one side from the positions of the connection portion 220 and the fixing portion 230, to also allow smooth discharge of air bubbles in the surrounding area where soldering is directly performed.

In other words, the discharge paths 330, 1330, 2330 of the different embodiments have the same purpose, function, and effect, but differ in the support area of the component reinforcing plate 310 and the air bubble discharge path. Therefore, the most suitable example can be selected in consideration of the type of electronic component 200 to be mounted, the size of the printed circuit board 10, the installation position, and the like.

Therefore, a printed circuit board 10 according to an embodiment of the present disclosure includes a discharge path 330 for discharging air bubbles within a component adhesive layer 320, which expand during a process of mounting an electronic component 200. As a result, the stability of the electrical connection between the electronic component 200 and a circuit layer 103 may be ensured, and a component reinforcing portion 300 may also be stably fixed, thereby improving the reliability and durability of the product.

Furthermore, defects that may occur due to a decrease in the flatness of the printed circuit board 10 caused by air bubbles may be prevented. In addition, problems such as a decrease in tensile strength with the electronic component 200 and a decrease in electrical connection stability may be resolved, thereby improving the reliability of an external device connected to the printed circuit board 10.

While the foregoing has described exemplary embodiments, it is to be understood that the present disclosure is not limited to the specific embodiments described, and that various changes and modifications may be made within the scope of the appended claims, and such changes and modifications are intended to be included within the scope of the present disclosure.

## Claims

1. A printed circuit board comprising:
a substrate portion (100) in which first and second insulating layers (101, 102) are formed one above the other, and a circuit layer (103) is formed between the first and second insulating layers (101, 102);
an electronic component (200) mounted in an exposed area (131) where the circuit layer is exposed by removing a portion of the first insulating layer (101); and
a component reinforcing portion (300) attached to the second insulating layer (102) at a position corresponding to the exposed area (131) and configured to support the electronic component (200),
wherein the component reinforcing portion (300) comprises:
a component reinforcing plate (310) bonded to the second insulating layer (102) of the exposed area (131), a component adhesive layer (320) formed between the second insulating layer (102) and the component reinforcing plate (310), and a fuse adhesive layer (340) formed on a surface of the component reinforcing plate (310) opposite to the component adhesive layer (320),
wherein the substrate portion (100) further comprises:
a pattern fuse portion (150) formed such that a portion of the circuit layer (103) is configured to function as a fuse,
wherein the pattern fuse portion (150) comprises a fusing portion (151) configured to fuse faster than other portions of the circuit layer (103) at or above a predetermined current, and
wherein one surface of the pattern fuse portion (150) is attached and fixed to the fuse adhesive layer (340).

2. The printed circuit board of claim 1, wherein
the component reinforcing portion (300) further comprises:
a discharge path (330, 1330, 2330) configured to discharge air bubbles within the component adhesive layer (320).

3. The printed circuit board of claim 2, wherein
the electronic component (200) comprises a connection portion (220) that is electrically connected by soldering to the circuit layer (103) exposed in the exposed area (131), and the discharge path (330, 1330, 2330) is formed at a position corresponding to the connection portion (220).

4. The printed circuit board of claim 3, wherein
the discharge path (330, 1330, 2330) comprises:
a horizontal discharge path (331) formed by removing the component adhesive layer (320) at the position of the connection portion; and
a vertical discharge path (332) formed to pass through the component reinforcing plate (310) so as to be in communication with the horizontal discharge path (331).

5. The printed circuit board of claim 4, wherein
the fuse adhesive layer (340) is formed on portions other than a location corresponding to the fusing portion (151) to form an air gap (345) at the location corresponding to the fusing portion (151), and
wherein the vertical discharge path (332) is formed to be in communication with the air gap (421).

6. The printed circuit board of claim 2, wherein
a fixing circuit (132) to which the electronic component (200) is fixed by soldering is formed in the exposed area (131), and wherein the discharge path (330, 1330, 2330) is additionally formed at a position corresponding to a position of the fixing circuit (132).

7. The printed circuit board of claim 1, wherein
the fuse adhesive layer (340) is formed on a remaining portion excluding a position corresponding to the fusing portion (151), thereby forming an air gap (345) at the position corresponding to the fusing portion (151).

8. The printed circuit board of claim 1, wherein
the pattern fuse portion (150) further comprises:
connection pads (152) formed at both ends of the fusing portion (151).

9. The printed circuit board of claim 8, wherein
a width of the connection pads (152) is wider than a width of the fusing portion (151).

10. The printed circuit board of claim 8, wherein
at least one of the first insulating layer (101) or the second insulating layer (102) is not formed at a location where the connection pads (152) are formed, such that the connection pad (152) is exposed to an exterior.

11. The printed circuit board of claim 10, wherein
a protective coating liquid is applied on an upper side of the connection pads (152).

12. The printed circuit board of claim 8, wherein
the pattern fuse portion (150) further comprises:
an interference prevention portion (153) surrounding the fusing portion (151), wherein the circuit layer (103) is removed in the interference prevention portion (153).

13. The printed circuit board of claim 8, wherein
the pattern fuse portion (150) further comprises:
a concentrated fusing portion (154) in which at least one of the first insulating layer (101) or the second insulating layer (102) is open over at least a portion of the fusing portion (151).

14. The printed circuit board of claim 13, wherein
a protective coating liquid is applied to an opened surface of the concentrated fusing portion (154).

15. The printed circuit board of claim 8, wherein
the pattern fuse portion (150) further comprises:
an overflow prevention portion (155) formed as a closed curve surrounding the pattern fuse portion (150) and protruding from at least one of the first insulating layer (101) or the second insulating layer (102).

16. The printed circuit board of claim 3, wherein
the discharge path (330, 1330, 2330) is
formed as an air tunnel (1331) in which the component adhesive layer (320) is removed from a position of the connection portion (220) to one side end of the exposed area (131).

17. The printed circuit board of claim 1, wherein
the component reinforcing portion (300) further comprises:
a component reinforcing portion fixing hole (311) formed through the component reinforcing portion (300).

18. The printed circuit board of claim 3, wherein the discharge path (330, 1330, 2330) is
formed as an air hole (2331, 2332) that penetrates the component reinforcing plate (310) and the component adhesive layer (320) at a position of the connection portion (220).
